# EUROPEAN PATENT SPECIFICATION

(11) **EP 1 968 352 B1**
(45) Date of publication and mention of the grant of the patent: **28.10.2009**
(21) Application number: 08003656.9
(22) Date of filing: 28.02.2008
(51) Int. Cl.: H05B 1/02, H05B 3/68, H01L 21/00

(54) **Thermostat and testing machine provided with the same**
Thermostat und Testgerät damit
Thermostat et machine d'essai dotée ce celui-ci

(30) Priority: 05.03.2007 JP 2007054479
(43) Date of publication of application: 10.09.2008
(73) Proprietor: Espec Corp., Kita-ku Osaka-shi Osaka 530-8550 (JP)
(72) Inventor: Nakanishi, Masataka, Osaka-shi Osaka 530-8550 (JP); Kurara, Hironobu, Osaka-shi Osaka 530-8550 (JP); Nishikawa, Taihei, Osaka-shi Osaka 530-8550 (JP)
(74) Representative: Paul, Dieter-Alfred

(56) References cited:
- JP-A- 10 288 646
- JP-A- 61 074 340
- US-A1- 2005 040 155
- US-A1- 2006 244 472

## Description

### BACKGROUND OF THE INVENTION

### FIELD OF THE INVENTION

The present invention relates to thermostats and testing machines, and more specifically to a thermostat (so-called "a thermal plate") for use in testing performance of a semiconductor wafer, on which an electronic circuit is formed, and to a testing machine provided with the thermostat.

### DESCRIPTION OF THE RELATED ART

Electronic devices as typified by a mobile phone and a personal computer are in widespread use. Recently, these electronic devices are used for various purposes or in various environments. That is why environment tests should be conducted on the electronic devices themselves or their components such as integrated circuits. A thermostat called a "thermal plate" is used as a device for exposing these electronic devices or components to a high-temperature or low-temperature environment.

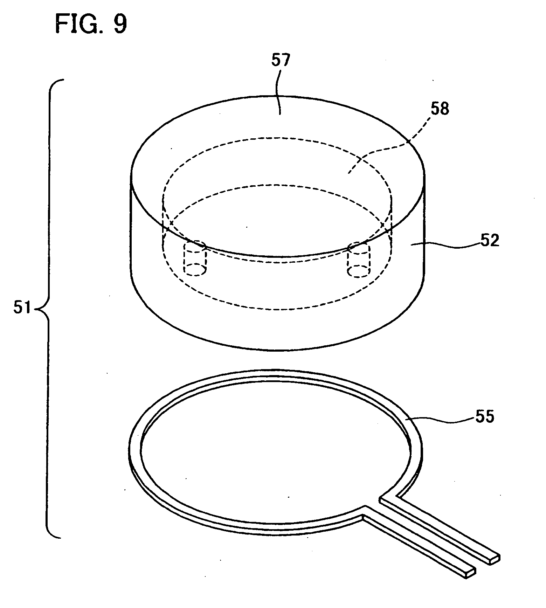

A common thermal plate has a configuration shown in Fig. 9. A thermal plate 51 shown in Fig. 9 has a plate body 52 and an electric heater 55. The plate body 52 is of a flat columnar shape and has a top face functioning as a mounting face 57 on which an article to be tested is placed or held. Further, the plate body 52 defines therewithin a cavity 58 into which a heat transfer medium is introduced. The electric heater 55 is provided in thermal contact with the bottom of the plate body 52 so as to increase temperature of the mounting face 57. Both controlling of the electric heater 55 and introduction of a heat transfer medium into the cavity 58 keep the temperature of the mounting face 57 at a desired temperature. In order to keep the temperature of the mounting face 57 at a lower temperature, for example, a low-temperature fluid is introduced into the cavity 58. In this way, electronic devices or their components placed or fixed on the mounting face 57 can be exposed to a high-temperature or low-temperature environment.

A testing machine provided with a thermal plate or a thermostat having a configuration disclosed in the below-listed patent document 1 or 2 is known. The testing machine disclosed in the patent documents 1 and 2 each include a thermal plate (so called a "temperature controlled chuck") and conduct tests with a semiconductor wafer placed or fixed on the thermal plate.
Patent Document 1: JP 2005-45039 A
Patent Document 2: JP 10-288646 A

### SUMMARY OF THE INVENTION

### PROBLEMS TO BE SOLVED BY THE INVENTION

A thermal plate is used for changing temperature of an article such as an integrated circuit placed on a mounting face so as to conduct predetermined tests. Thus, it is preferable to show much less temperature variation across the mounting face of the thermal plate. Those skilled in the art are therefore most interested in temperature variation across the mounting face. That is why studies or measures to lessen temperature variation across the mounting face are executed. The thermal plate disclosed in the patent document 1, for example, supplies a cooling medium to a specific location so as to lessen temperature variation. This thermal plate achieves smaller temperature variation than one previous thereto. However, temperature variation across a mounting face is fundamental performance of a thermal plate as described above. In the marketplace, such a thermal plate as showing less temperature variation has been desired.

The present invention aims to provide a thermal plate or a thermostat showing less temperature variation across a mounting face on which an article is placed.

### MEANS TO SOLVE THE PROBLEM

An aspect of the present invention is a thermostat including a plate body having a mounting face on which an article is to be placed or held, further having an outer periphery, and defining a cavity into which a heat transfer medium is to be introduced, and a heat insulator covering the outer periphery of the plate body, the thermostat being adapted to adjust temperature of the mounting face at a predetermined temperature by introduction of a heat transfer medium into the cavity.

Thus, the thermostat of the present aspect prevents heat intrusion and/or dissipation from the outer periphery of the plate body in transferring heat between the mounting face and a heat transfer medium within the cavity. That reduces the thermal influence on the mounting face, thereby ensuring more uniform temperature distribution on the mounting face.

Preferably, the plate body is of a flat columnar shape with a top face and a side face, the top face constituting the mounting face, and the side face constituting the outer periphery.

In the thermostat of this preferred aspect, the plate body is of a flat columnar shape, so as to ensure more uniform heat transfer between the mounting face and the heat transfer medium. That achieves more uniform temperature distribution on the mounting face.

Preferably, the thermostat further includes a heater for increasing temperature of the mounting face.

The thermostat of this preferred aspect adjusts temperature of the mounting face more accurately and in broader range.

Preferably, the heater is provided in thermal contact with the bottom of the plate body.

Another aspect of the present invention is a testing machine provided with the thermostat as described above, and having a medium introducing section for introducing a heat transfer medium, which is at a predetermined temperature, into the cavity.

This aspect relates to a testing machine, which includes the thermostat of the present invention and further includes a medium introducing section for introducing a heat transfer medium, which is at a predetermined temperature, into the cavity. The testing machine of the present aspect achieves more uniform temperature distribution on the mounting face of the plate body, thereby conducting environment tests more accurately on electronic devices or their components.

### ADVANTAGEOUS EFFECT OF THE INVENTION

The thermostat of the present invention shows less temperature variation across the mounting face, thereby providing a testing machine adapted to conduct tests more accurately on electronic devices or their components.

The same can be said to the testing machine of the present invention, which is adapted to conduct tests more accurately on electronic devices or their components by means of the thermostat showing less temperature variation across the mounting face.

### BRIEF DESCRIPTION OF THE DRAWINGS

Fig. 1 is a perspective view of a thermal plate (thermostat) of a first embodiment of the present invention;
Fig. 2 is an exploded perspective view of the thermal plate in Fig. 1;
Fig. 3 is a cross-sectional perspective view of the thermal plate in Fig. 1;
Fig. 4 is a cross section of the thermal plate in Fig. 1 on which a semiconductor wafer is placed;
Fig. 5A and 5B show a plate body of a thermal plate (thermostat) of a second embodiment of the present invention, Fig. 5A being a plan view thereof, and Fig. 5B being a cross section taken along a line A-A in Fig. 5A;
Fig. 6 is a cross-sectional perspective view of the thermal plate of the second embodiment of the present invention;
Fig. 7 is a cross section of the thermal plate in Fig. 6 on which a semiconductor wafer is placed;
Fig. 8 is a perspective view of a testing machine of an embodiment of the present invention; and
Fig. 9 is an exploded perspective view of a thermal plate in the prior art.

### DESCRIPTION OF THE PREFERRED EMBODIMENT

Now, embodiments of the present invention will be described in detail below, making reference to the accompanying drawings.

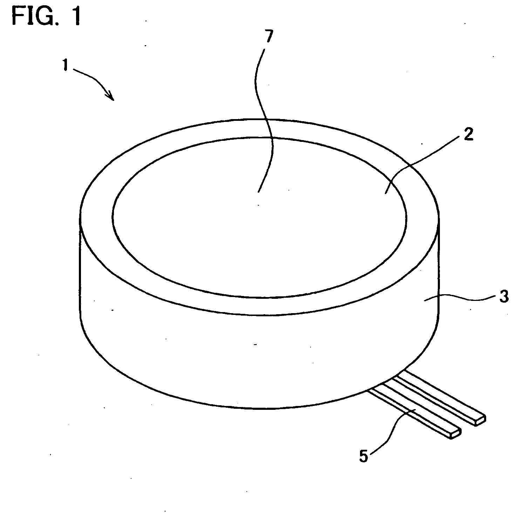

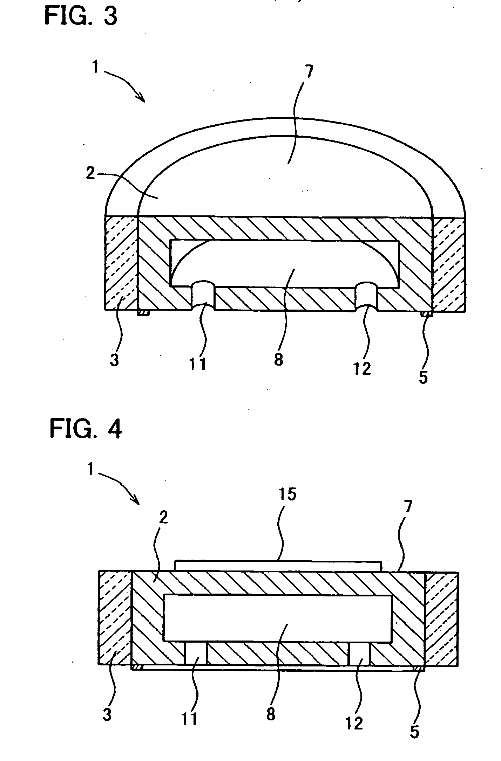

A thermostat (so-called thermal plate) 1 shown in Figs. 1 to 4 is incorporated in a so-called wafer prober and mainly consists of a plate body 2, a heat insulator 3, and an electric heater 5. The plate body 2 is made of metal and of a low and flat columnar shape. The plate body 2 has a top face, which functions as a mounting face 7 on which an article such as a semiconductor wafer 15 (Fig. 4) to be tested is placed.

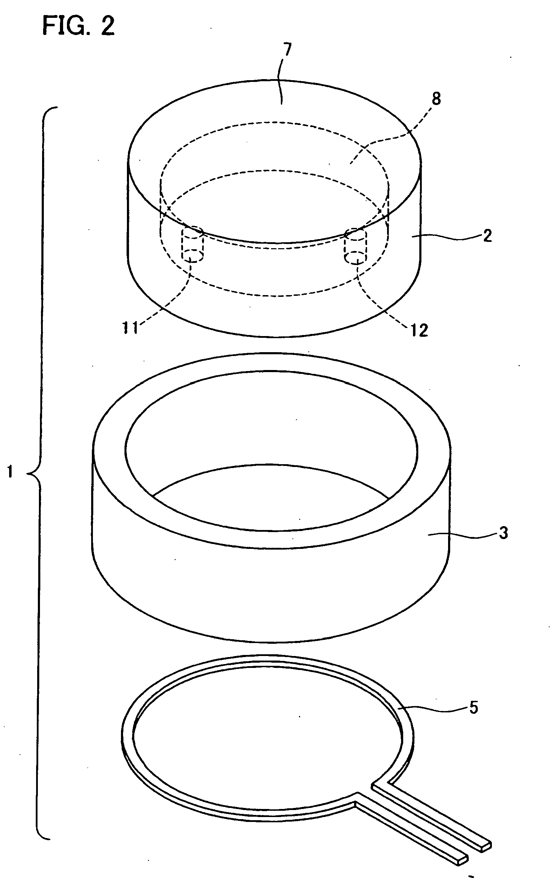

As shown in Figs. 2 to 4, the plate body 2 defines a cavity 8 therewithin. Further, the plate body 2 has a bottom face with two openings 11 and 12, which communicate with the cavity 8 so as to introduce therethrough a cooling medium (heat transfer medium) into the cavity 8. The opening 11 functions as a cooling medium inlet, whereas the opening 12 functions as a cooling medium outlet. The opening 11 is connected to a cooling medium introducing section (medium introducing section for introducing a heat transfer medium) not shown, whereby a cooling medium is sent to the opening 11.

Referring to Figs. 1 to 4, the heat insulator 3 is attached to the plate body 2 so as to cover an outer periphery of the plate body 2. The heat insulator 3 is of a hollow cylindrical shape and has an inner diameter and height that are substantially identical to an outer diameter and height, respectively, of the plate body 2. The heat insulator 3 is made of a material such as a glass wool, a machinable ceramics (for example, well-insulating "Photoveel": registered trademark of Sumikin Ceramics & Quartz Co., Ltd.). In the thermal plate 1 of the present embodiment, the outer periphery of the plate body 2 is covered with the heat insulator 3, which prevents heat intrusion and/or dissipation from the outer periphery of the plate body 2 in transferring heat between the mounting face 7 and a cooling medium (heat transfer medium) within the cavity 8. That reduces the thermal influence on the mounting face 7, thereby ensuring more uniform temperature distribution on the mounting face 7. Herein, in the present embodiment, the heat insulator 3 covers all over the outer periphery of the plate body 2, but may cover part of the periphery. The heat insulator 3 may, for example, cover only an upper half of the outer periphery of the plate body 2.

As shown in Fig. 2, the electric heater 5 is of a substantially annular shape and has a diameter that is substantially identical to that of the bottom of the plate body 2. The heater 5 is located on a peripheral part of the bottom and in thermal contact with the bottom of the plate body 2. In the thermal plate 1, heat generation of the heater 5 and cooling by a cooling medium introduced into the cavity 8 adjust the temperature of the mounting face 7 that is a surface of the plate body 2.

A semiconductor wafer (article) 15 would be placed on the mounting face 7 of the thermal plate 1 of the present embodiment as shown in Fig. 4, for example. Specifically, the semiconductor wafer 15 having a diameter slightly smaller than that of the mounting face 7 is placed on substantially the center of the mounting face 7. Actually, the mounting face 7 has a limited area for the semiconductor wafer 15 to be placed. Thus, the semiconductor wafer having a diameter that is identical to that of the mounting face 7 cannot be placed on the face 7. Herein, the mounting face 7 may form a groove or grooves for fixing an article onto the face, an aperture or apertures for attaching an article under suction onto the face, or the like.

In the above-mentioned embodiment, the thermal plate 1 includes the heater 5, but the present invention may dispense with the heater 5.

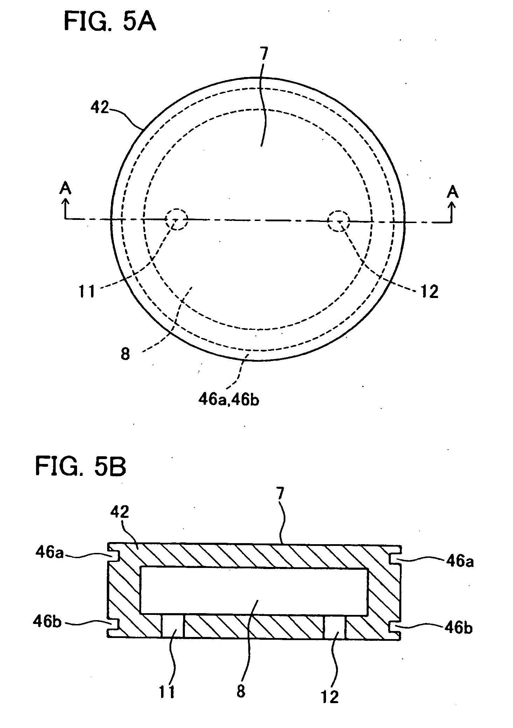

In the above-mentioned embodiment, the plate body 2 has the periphery of a smoothly curved surface without irregularities, but the present invention is not limited thereto and may have a configuration as shown in Figs. 5A to 7. In Figs. 5A to 7, the same numerals are assigned to the same components in Figs. 1 to 4 for easier comprehension.

In the embodiment shown in Figs. 5A to 7, a plate body 42 has two depressed portions 46a and 46b all round an outer periphery of the plate body 42. The depressed portions 46a and 46b each are an annular U-shaped groove formed by means such as cutting. One depressed portion 46a is formed between the mounting face 7 and the cavity 8 relative to a thickness direction of the plate body 42, whereas the other depressed portion 46b is formed between the bottom (face opposite to the mounting face 7) and the cavity 8 relative to the thickness direction thereof. Further, the depressed portions 46a and 46b both have depths in a radial direction shorter than a distance between the outer periphery of the plate body 42 and a side wall of the cavity 8.

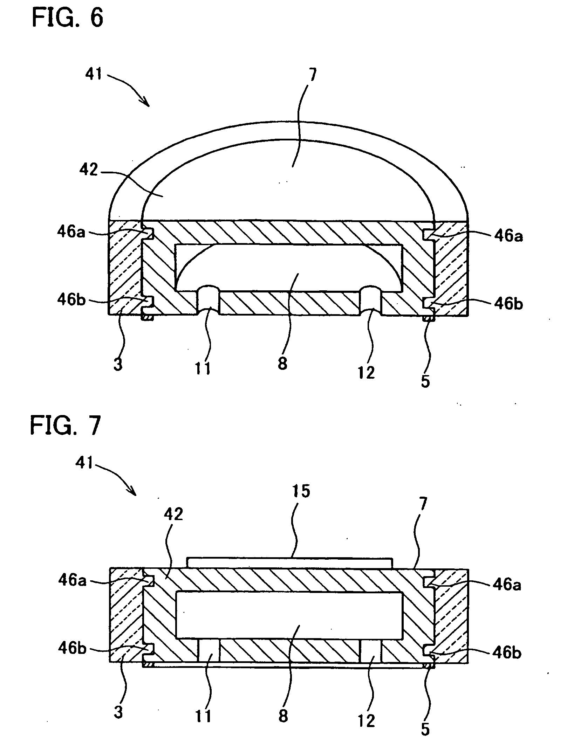

In the present embodiment, the heat insulator 3 is formed around the plate body 42, thereby allowing part of the heat insulator 3 to fit into the depressed portions 46a and 46b, as shown in Figs. 6 and 7. That gives an increased sealing performance of the heat insulator 3. In the case such as deterioration of the heat insulator 3, the heat insulator 3 is easily renewed. Further, the present embodiment forms the depressed portions 46a and 46b around the outer circumference of the plate body 42, so as to reduce the thermal influence (heat intrusion and/or dissipation, for example) from the outer circumference onto the heat conduction between the mounting face 7 and the cavity 8, thereby ensuring more uniform temperature distribution on the mounting face 7.

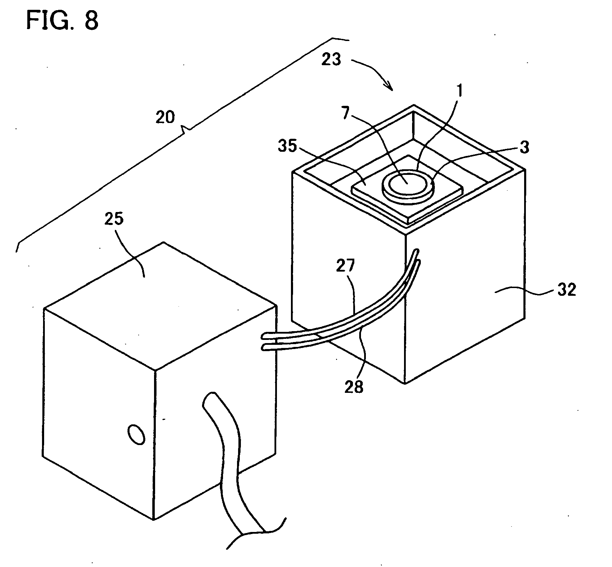

Now, a testing machine will be described below. Fig. 8 is a perspective view of a testing machine of an embodiment of the present invention. As shown in Fig. 8, a testing machine 20 of the present embodiment is roughly divided into two devices, more specifically, into a testing section 23 incorporating the thermal plate 1 and a gas supplying device (medium introducing section for introducing a heat transfer medium) 25. The testing section 23 and the supplying device 25 are connected therebetween by an inlet connecting pipe 27 and an outlet connecting pipe 28. The supplying device 25 incorporates a cooling element so as to cool air. The testing section 23 belongs to a wafer prober.

The thermal plate 1 is housed in a casing 32 that is independent of the supplying device 25. The casing 32 has therein two pipes, which connect the inlet connecting pipe 27 to the opening 11 (Figs. 2 to 4) and the outlet connecting pipe 28 to the other opening 12 (Figs. 2 to 4), respectively. Cooled air is introduced into the cavity 8 through the opening 11 from the supplying device 25. Heat generation by the heater 5 (Figs. 1 to 4) and cooling by the cooled air having been introduced into the cavity 8 adjust temperature of the mounting face 7. Temperature and flow rate of the cooled air to be introduced into the cavity 8 and output of the heater 5 are regulated so that temperature of the mounting face 7 is adjustable at least in the range from minus 70 degrees Centigrade to 200 degrees Centigrade.

As described above, since the thermal plate 1 has the heat insulator 3 around the plate body 2, the testing machine 20 achieves more uniform temperature distribution on the mounting face 7. According to the testing machine 20 of the present embodiment, tests for a component such as a semiconductor wafer are conducted with a higher degree of accuracy. The thermal plate 1 is placed on an XY table 35 and is movable in X and Y directions by a motor not shown.

In the present embodiment, the heat transfer medium to be introduced into the cavity 8 is a cooled air, but is not particularly limited thereto only if the medium is a fluid, and may have no preference between a cooling fluid and a heating fluid.

The present embodiment employs the thermal plate 1 shown in Figs. 1 to 4, but may employ a thermal plate 41 shown in Figs. 5A to 7.

## Claims

1. A thermostat (1) comprising:
a plate body (2) having a mounting face (7) on which an article is placed or held, further having an outer periphery, and defining a cavity (8) into which a heat transfer medium is to be introduced; and
the thermostat (1) being adapted to adjust temperature of the mounting face (7) at predetermined temperature by introduction of a heat transfer medium into the cavity (8) **characterised by** a heat insulator (3) covering the outer periphery of the plate body (2).

2. The thermostat (1) as defined in claim 1,
wherein the plate body (2) is of a flat columnar shape with a top face and a side face,
the top face constituting the mounting face (7), and
the side face constituting the outer periphery.

3. The thermostat (1) as defined in claim 1 or 2,
further comprising a heater (5) for increasing temperature of the mounting face (7).

4. The thermostat (1) as defined in claim 2,
further comprising a heater (5) for increasing temperature of the mounting face (7), the heater (5) being provided in thermal contact with the bottom of the plate body (2).

5. A testing machine provided with the thermostat (1) as defined in one of claims 1 to 4, and having a medium introducing section for introducing a heat transfer medium, which is at a predetermined temperature, into the cavity (8).

## Patentansprüche

1. Ein Thermostat (1) umfassend:
einen Plattenkörper (2), der eine Montagefläche (7) hat, an welcher ein Artikel platziert oder gehalten wird, der weiterhin einen Außenumfang hat und der eine Kavität (8) definiert, welche dazu bestimmt ist, ein Wärmeübertragungsmedium einzufüllen;
wobei der Thermostat (1) geeignet ist, die Temperatur der Montagefläche (2) auf eine vorgegebene Temperatur einzustellen, indem ein Wärmeübertragungsmedium in die Kavität (8) eingefüllt wird, **gekennzeichnet durch** einen Wärmeisolator (3), der den Außenumfang des Plattenkörpers (2) abdeckt.

2. Der Thermostat (1) wie in Anspruch 1 definiert, worin der Plattenkörper (2) eine flache, säulenartige Form mit einer Oberseite und einer Seitenfläche besitzt, wobei die Oberseite die Montagefläche (7) bildet und die Seitenfläche den Außenumfang bildet.

3. Der Thermostat (1) wie in Anspruch 1 oder 2 definiert, mit weiterhin einer Heizvorrichtung (5), um die Temperatur der Montagefläche (7) zu erhöhen.

4. Der Thermostat (1) wie in Anspruch 2 definiert, mit weiterhin einer Heizvorrichtung (5) zur Erhöhung der Temperatur der Montagefläche (7), wobei die Heizvorrichtung (5) in thermischem Kontakt mit dem Boden des Plattenkörpers (2) vorgesehen ist.

5. Eine Testmaschine, die mit dem Thermostat (1), wie er in einem der Ansprüche 1 bis 4 definiert ist, versehen ist und einen Mediumeinfüllabschnitt zum Einfüllen eines Wärmeübertragungsmediums, das sich auf einer vorgegebenen Temperatur befindet, in die Kavität (8) aufweist.

## Revendications

1. Un thermostat (1) comprenant:
- un corps de plaque (2) ayant une face de montage (7) sur laquelle un article est placé ou tenu, ayant de plus une périphérie extérieure et définissant une cavité (8) dans laquelle un moyen de transfert de chaleur est pour être introduit: et
- le thermostat (1) étant adapté pour ajuster la température de la face de montage (7) à la température prédéterminée par l'introduction d'un moyen de transfert de chaleur dans la cavité (8) **caractérisé par** un isolateur de chaleur (3) couvrant la périphérie extérieure du corps de plaque (2).

2. Le thermostat (1) comme défini dans la revendication 1,
- où le corps de plaque (2) est en forme de colonne plate avec une face supérieure et une face latérale,
- la face supérieure constituant la face de montage (7), et
- la face latérale constituant la périphérie extérieure.

3. Le thermostat (1) comme défini dans la revendication 1 ou 2, comprenant de plus un réchauffeur (5) pour croître la température de la face de montage (7).

4. Le thermostat (1) comme défini dans la revendication 2, comprenant de plus un réchauffeur (5) pour croître la température de la face de montage (7), le réchauffeur (5) étant pourvu en contact thermique avec le bas du corps de plaque (2).

5. Une machine d'essai pourvue avec le thermostat (1) comme défini dans l'une d'entre les revendications 1 à 4, et ayant une section moyenne d'introduction pour introduire un moyen de transfert de chaleur, qui est à une température prédéterminée, dans la cavité (8).
